# EUROPÄISCHE PATENTANMELDUNG

(11) **EP 2 866 537 A1**
(43) Veröffentlichungstag der Anmeldung: **29.04.2015**
(21) Anmeldenummer: 13401117.0
(22) Anmeldetag: 25.10.2013
(51) Int. Cl.: H05K 5/02, E05B 45/00, E05B 51/02, G08B 13/00

(54) **Telematik-Modul mit Saugnapf und Überwachung des Saugnapfdrucks**

(71) Anmelder: TSI Technologie, Service, Innovation GmbH, 15745 Wildau (DE)
(72) Erfinder:
(74) Vertreter: Farago, Peter Andreas

(57) **Zusammenfassung**

Die vorliegende Erfindung betrifft eine Telematik-Vorrichtung und ein Verfahren, wobei ein Telematik-Modul (1) über einen Saugnapf (3) mit einer glatten Oberfläche (20) eines zu überwachenden Gegenstandes verbunden und diese Verbindung überwacht werden können, das Telematik-Modul (1) umfassend:
- eine Elektronik mit einem Funkmodul (7) zur drahtlosen Kommunikation mit einer Überwachungsstation (21);
- ein Gehäuse (2) mit dem Saugnapf (3), der aus gebildet ist, über eine Saugnapflippe mit der Oberfläche (20) dicht abzuschließen und dabei hinter der Oberfläche (20) einen Hohlraum (4) zu bilden, um durch einen Unterdruck das Gerät (2) an der Oberfläche (20) zu halten; dadurch gekennzeichnet, dass die Elektronik einen Drucksensor (5), der mit dem Hohlraum (4) verbunden ist, und einen Detektor (6) zur Überwachung eines Drucksignals aufweist,
wobei vom Detektor erkannt wird, wenn eine Drucksignaländerung einen Schwellwert, der für ein unerlaubtes Lösen typisch ist, überschreitet, und die Elektronik ein Alarmsignal ausgelöst, abspeichert und zur Überwachungsstation (21) überträgt.

## Beschreibung

Die vorliegende Erfindung betrifft eine Telematik-Vorrichtung ein Telematik-Modul umfassend, das über einen Saugnapf mit einem zu überwachenden Gegenstand einfach verbunden und wieder abgelöst werden kann. Ein Detektor überwacht dabei einen Innendruck des Saugnapfs und detektiert dadurch ein unerlaubtes Lösen des Telematik-Moduls vom zu überwachenden Gegenstand.

### Hintergrund der Erfindung und Stand der Technik

Telematikgeräte zur diebstahlsicheren Überwachung eines Gegenstands, wie beispielsweise eines Fahrzeugs, eines Containers oder dergleichen, werden üblicherweise fest mit dem Gegenstand verbunden. Dabei wird das Telematikgerät entweder versteckt eingebaut, wie beispielsweise bei Autodiebstahlalarmanlagen, die per GSM Mobilfunk oder ähnlich eine Benachrichtigung einer unerlaubten Bewegung des Fahrzeugs absenden. Oder es kann das Telematikgerät auch einmalig so fest mit dem Gegenstand verbunden werden, dass es bei einem Lösen zerstört wird, wie beispielsweise bei RFID Aufklebern. Telematikgeräte werden beispielsweise eingesetzt zu einer Überwachung einer Position, von Beschleunigungen oder Abbremsungen, von Temperatur, von Fahrzeugparametern, Batteriestand und dergleichen.

Meist besteht ein Bedarf das Telematikgerät zuverlässig mit dem zu überwachenden Gegenstand zu verbinden und zu verhindern, dass das Telematikgerät unerlaubter Weise davon gelöst wird. Daher ist es vorteilhaft, das Telematikgerät, das mit zu überwachenden Gegenstand verbunden wird, möglichst klein und leicht zu gestalten. Andererseits sind in dem Telematikgerät oft eine Reihe von Sensoren, Elektronik und ein Funkmodul für große Distanzen, beispielsweise basierend auf einem Funkstandard wie GSM, GPRS, UMTS, LTE oder dergleichen, nötig, so dass der Energieverbrauch eine entsprechend große und schwere Batterie zur Stromversorgung benötigt.

DE 20 2012 103 024 U1 offenbart beispielsweise ein Gehäuse für ein Telematikgerät zur Sicherheitsüberwachung für ein Flottenmanagement, das Befestigungselemente, wie beispielsweise Magnete, Saugnäpfe oder Klebeelemente, zur Verbindung mit dem zu überwachenden Gegenstand aufweist. Zur Detektion eines unerlaubten Lösens des Telematikgeräts vom zu überwachenden Gegenstand sind am Gehäuse magnetische Sensoren zur Detektion einer Anhaftung an einem magnetischen Gegenstand oder Näherungssensoren angebraucht. Die technische Ausführung ist jedoch aufwendig, teuer und problematisch in einer zuverlässigen Detektion des unerlaubten Lösens vom zu überwachenden Gegenstand. Zudem erfordert der offenbarte apparative Mehraufwand zur Detektion des unerlaubten Lösens auch einen höheren Energieaufwand und daher auch eine größere Batterie oder Akku. Damit wird das Telematikgerät größer und schwerer.

Die derzeitigen Befestigungsvorrichtungen für Telematikgeräte weisen beispielsweise als Saugnäpfe und Magnethalter keine zuverlässige Detektion eines unerlaubten Lösens auf, oder sie sind kompliziert, energieverbrauchend und schwer, oder sie müssen auf dem zu überwachenden Gegenstand fest aufgeklebt werden, was ein Lösen erschwert und Spuren hinterlässt.

### Zusammenfassung der Erfindung

Aufgabe der Erfindung ist es daher, um die Nachteile aus dem Stand der Technik zu vermeiden, eine Telematik-Vorrichtung bereitzustellen, die von Hand einfach mit einem zu überwachenden Gegenstand mit einer glatten Oberfläche verbunden und von diesem wieder gelöst werden kann, deren Verbindung mit dem zu überwachenden Gegenstand zuverlässig überwacht wird, und die möglichst klein, leicht und stromsparend ist.

Die vorstehende Aufgabe sowie weitere, der Beschreibung zu entnehmende Aufgaben werden durch eine Telematik-Vorrichtung und ein Verfahren gemäß der Merkmalskombination des unabhängigen Anspruchs 1 bzw. 15 gelöst.

Weitere vorteilhafte Ausführungsformen der Erfindung sind in den abhängigen Ansprüchen angegeben.

Gemäß der vorliegenden Erfindung umfasst die Telematik-Vorrichtung ein Telematik-Modul mit einem Saugnapf zur Verbindung mit einer glatten Oberfläche eines zu überwachenden Gegenstandes, wobei ein Lösen der Verbindung erkannt und ein Alarmsignal ausgelöst wird und das Telematik-Modul folgendes umfasst:
- eine Elektronik mit einem Mikroprozessor mit Ablaufsteuerung und einem Funkmodul zur drahtlosen Übertragung von Telematikmoduldaten zu einer Überwachungsstation;
- ein Gehäuse, in der die Elektronik untergebracht ist;
- den Saugnapf, der mit dem Gehäuse fest verbunden und so ausgebildet ist, an einer Unterseite des Gehäuses nach außen hin eine überstehende, umlaufende Saugnapflippe aufzuweisen, die sich bei einem Andrücken auf der glatten Oberfläche an diese anpasst und mit dieser dicht abschließt, wobei in einem Innern zwischen der umlaufenden Saugnapflippe und zur Oberfläche hin offen ein Hohlraum ausgebildet ist, um bei einem Unterdruck im Hohlraum ein Ansaugen an die Oberfläche und damit die Verbindung des Telematik-Moduls zu bewirken;
wobei
- die Elektronik einen Drucksensor umfasst, der mit dem Hohlraum des Saugnapfs verbunden ist und ein entsprechendes Drucksignal erzeugt;
- die Elektronik einen Detektor zur Überwachung des Drucksignals umfasst, der ausgebildet ist, eine Drucksignaländerung zu bestimmen und mit mindestens einem Schwellwert zu vergleichen, um bei einer Überschreitung des mindestens einen Schwellwerts das Lösen der Verbindung zu erkennen und daraufhin das Alarmsignal zu erzeugen, wobei der mindestens eine Schwellwert charakteristisch für ein unerlaubtes Lösen des Telematik-Moduls von der Oberfläche ist und im Detektor abgespeichert ist; und
- die Elektronik das Alarmsignal speichert und daraufhin mit den Telematikmoduldaten zur Überwachungsstation überträgt.

Im Unterschied zum Stand der Technik muss das Telematik-Modul, um zuverlässig einen Gegenstand überwachen zu können, nicht festgeklebt, über einen Schalter detektierbar festgeschraubt oder versteckt werden, um einem unerlaubten Lösen des Telematik-Moduls vom zu überwachenden Gegenstand vorzubeugen oder diese Verbindung zu überwachen. Auch müssen dafür nicht wie im Stand der Technik kostenintensive Näherungssensoren oder eine aufwendige Bewegungsmeldung vorgenommen werden, die zudem fehleranfällig sind. Vielmehr wird gemäß der vorliegenden Erfindung zur Überwachung gegen das unerlaubte Lösen der mechanischen Verbindung mit wenig Aufwand der Drucksensor vorgesehen und mit dem Hohlraum des Saugnapfs verbunden, um dessen Unterdruck einfach überwachen zu können. Der Detektor zur Überwachung des Drucksensorsignals ist zudem einfach und kostengünstig und nimmt zusammen mit dem Drucksensor nur sehr wenig Bauraum in Anspruch.

Bevorzugt können im Detektor auch auf einfache Weise eine Vielzahl von Schwellwerten abgespeichert und überwacht werden, die jeweils typisch für eine jeweilige Art eines Lösens der Verbindung sind. Die Schwellwerte werden dabei so eingestellt, dass sowohl ein schnelles, als auch sehr langsames Ablösen der Verbindung erkannt wird. Dabei werden bevorzugt alle möglichen Drucksignalverläufe verschiedener Arten des unerlaubten Lösens der Verbindung berücksichtigt, indem Klassen von Drucksignaländerungen gebildet werden und dafür die Schwellwerte bestimmt werden, die dann im Detektor auf einfache Weise abgespeichert werden können, um eben diese Klassen zu erkennen und von Klassen einer bestehenden Verbindung unterscheiden zu können. Auch ein Ablösen während eines Nachpumpens durch eine integrierte Vakuumpumpe, die eine bevorzugte Ausführungsform umfasst, kann detektiert werden, indem ein bei einem Pumpvorgang typischer Druckverlauf bestimmt und für einen entsprechenden Schwellwert berücksichtigt und im Detektor abgespeichert wird, um eine Abweichung davon dann zu erkennen, um das Alarmsignal richtig erzeugen zu können. Vorteilhafterweise kann die Elektronik in bestimmten Zeitintervallen das Drucksignal detektieren, die so bestimmt sind, dass nur wenig Strom verbraucht wird, wobei dann jeweils eine Drucksignaländerung bestimmt wird aus einem vorhergehenden ersten Drucksignalwert und dem aktuellen Drucksignalwert. Wenn die so bestimmte Drucksignaländerung einen ersten Schwellwert überschreitet, der anzeigt, dass ein Lösen der Verbindung vorliegen könnte, so werden bevorzugt in darauffolgenden kleineren Zeitintervallen weitere Bestimmungen der Drucksignaländerungen gegenüber dem ersten Drucksignalwert und im Vergleich zu dem gleichen und/oder auch weiteren Schwellwerten vorgenommen.

Bevorzugt ist im Telematik-Modul eine Vakuumpumpe integriert, durch deren Ansteuerung eine Leckage zwischen dem Saugnapf und der Oberfläche des zu überwachenden Gegenstandes kompensiert werden kann. So läßt sich das Telematik-Modul über eine beliebig lange Zeit mit der Oberfläche des zu überwachenden Gegenstandes verbinden, ohne dass dabei beispielsweise ein Abfallen oder ein manuelles Nachpumpen erforderlich wäre.

Bevorzugt wird ein leichtes Andrücken des Telematik-Moduls an der Oberfläche durch einen Überdruck im Saugnapf erkannt, um daraufhin das Andrücken elektronisch durch einen Detektor zu erkennen und die Vakuumpumpe zur Erzeugung des übrigen Unterdrucks anzusteuern, um einen bestimmten eingestellten oder abgespeicherten Halteunterdruck zu erzeugen. Ein undefiniertes Andrücken entfällt dabei und es ist sichergestellt, dass immer der gleiche bestimmte Halteunterdruck erzeugt wird, um das Telematik-Modul zuverlässig an der Oberfläche zu halten. Bevorzugt ist der bestimmte Halteunterdruck zwischen verschiedenen Telematik-Modulen unterschiedlich, so dass es Personen nicht ermöglicht wird, den bestimmten Unterdruck eines bestimmten Telematik-Modul zu kennen, um dadurch beispielsweise das Telematik-Modul über eine spezielle Ablöseeinheit mit einem äußeren Unterdruck ablösen und die Detektion des Lösens der Verbindung umgehen zu können. Auch dadurch, dass der Saugnapf bevorzugt zumindest teilweise elastisch ist, würde ein Abziehen des Telematik-Moduls durch einen äußeren Unterdruck auf jeden Fall zu einer Volumenänderung des Hohlraums führen, so dass eine Drucksignaländerung und eine Detektion des Lösens bewirkt würden.

Eine zusätzliche Sensorik mit Sensoren und Auswerte- und Ankoppelelektronik, die bevorzugt in dem Telematik-Modul vorgesehen sind, ermöglichen eine direkte Kopplung der Sensorik mit dem zu überwachenden Gegenstand. Dadurch kann beispielsweise ein Beschleunigungssensor sämtliche Bewegungen oder Beschleunigungen des Fahrzeugs aufnehmen und mit den Telematikmoduldaten übermitteln. Auf diese Weise lässt sich beispielsweise ein Fahrzeug als der zu überwachende Gegenstand ab Ankopplung und Verbindung des Telematik-Moduls mit diesem zuverlässig überwachen. Dabei können auch beispielsweise Positionssignale erfasst und mit den Telematikmoduldaten übertragen werden. Durch die Verbindung über den Saugnapf lässt sich das Telematik-Modul fast beliebig oft mit dem zu überwachenden Gegenstand verbinden und wieder lösen. Auch werden dabei keine Spuren wie beispielsweise Klebespuren oder Schraubverbindungsspuren hinterlassen.

Vorteilhaft bei der Überwachung der Verbindung durch die Überwachung des Drucksignals ist auch, dass diese Art der Überwachung mit wenig Strom- und Energieverbrauch auskommt, und dass deshalb die Batterie oder der Akku und damit das gesamte Telematik-Modul viel kleiner dimensioniert werden können, als wenn diese Überwachung mit beispielsweise mit Ultraschallsensoren oder Infrarotdetektoren vorgenommen würde.

Vorteilhafterweise können durch die Messung des Drucksensorsignals auch Bewegungen des zu überwachenden Gegenstandes ohne eine weitere Sensorik detektiert werden, wobei Bewegungen, die durch Beschleunigungen verursacht sind, den Saugnapf und die Saugnapflippe, die bevorzugt elastisch sind, entsprechend verformen. Durch die Verformung des Saugnapfs wird eine Volumenänderung des Hohlraums und dadurch eine Druckänderung im Hohlraum verursacht, die durch eine Schwellwertanalyse oder eine Mustererkennung detektierbar ist.

Alternativ zu einem Saugnapf, der durch Bewegungen oder Beschleunigungen verformbar ist, ist im Saugnapf bevorzugt mindestens ein Saugnapfabstandshalter in Richtung zur Oberfläche angeordnet, der trotz der Beschleunigungen einen bestimmten Abstand des Telematik-Moduls zur Oberfläche bewirkt. Dadurch führen beispielsweise Beschleunigungen oder Abbremsungen des Fahrzeugs als der zu überwachende Gegenstand nicht zu Druckschwankungen, die andernfalls vielleicht als ein Abziehen detektiert werden könnten.

Bevorzugt ist im Innern des Saugnapfs eine Solarzelle angeordnet, um das Telematik-Modul von außen beispielsweise durch eine Scheibe oder Windschutzscheibe hindurch mit Energie versorgen zu können. Auch entfällt dabei eine für eine Aufladung des Akkus im Telematik-Modul ansonsten notwendige Steckverbindung. Ein Kabelsalat beim Aufladen kann dadurch vermieden werden.

Insbesondere hat eine bevorzugte Ausführungsform der Telematik-Vorrichtung mit einem Datenfunkgerät zur Übertragung von Information zwischen dem Telematik-Modul und der Überwachungsstation den Vorteil, dass das Telematik-Modul sehr klein und leicht ausgeführt werden kann. Dabei sind im Telematik-Modul im Wesentlichen nur der Drucksensor, der Detektor zur Überwachung, ein Kurzstrecken-Funkmodul als dem Funkmodul und eine Energiequelle für die Elektronik notwendig, so dass der Stromverbrauch trotz der zuverlässigen Überwachung der Verbindung auf ein Mini mum reduziert werden kann. Besonders durch die Verwendung eines Kurzstrecken-Funkmoduls anstelle eins weitreichenden Langstrecken-Funkmoduls kann der Stromverbrauch reduziert werden. Bevorzugt kann im Telematik-Modul noch eine Sensorik integriert werden, um einen weiteren Zustand des Telematik-Moduls zu überwachen. Als das Datenfunkgerät eignet sich besonders gut auch ein Mobilfunkgerät, das kommerziell verfügbar und bei niedrigen bis mittleren Stückzahlen viel kostengünstiger als eine Neuentwicklung ist. Bevorzugt ist das Kurzstrecken-Funkmodul dabei ein Bluetooth Modul, wobei das Langstrecken- Funkmodul bevorzugt auf einem standardisierten Mobilfunkstandard basiert, wie beispielsweise GSM, GPRS, HSxPA, EDGE, UMTS, LTE oder CDMA. Bei Verwendung eines solchen kommerziell verfügbaren Datenfunkmoduls reduzieren sich die Entwicklungskosten und die Stückkosten erheblich, verglichen damit, als wenn das Langstrecken- Funkmodul im Telematik-Modul selbst integriert wäre. Vorteilhaft ist dabei auch, dass das kommerziell verfügbare Datenfunkmodul oder das Mobilfunkgerät durch eine entsprechende Applikation sehr einfach so ausgeführt werden kann, um als das in der vorliegenden Erfindung beschriebene Datenfunkmodul fungieren zu können.

Besonders vorteilhaft ist die vorliegende Erfindung bei einer Anwendung zur Überwachung eines Automobils als dem Fahrzeug oder dem zu überwachenden Gegenstand. Dabei kann das Telematik-Modul beispielsweise leicht an die Windschutzscheibe angedrückt werden, um eine erste Dichtigkeit zwischen dem Saugnapf und der Windschutzscheibe zu erzeugen, um daraufhin bevorzugt durch die Vakuumpumpe den Unterdruck zur Verbindung des Telematik-Moduls mit der Windschutzscheibe zu erzeugen. Andere Lösungen aus dem Stand der Technik zur Erzeugung des Unterdrucks, wie beispielsweise durch einen Hebel oder dergleichen, können natürlich anstelle der Vakuumpumpe auch eingesetzt werden.

Zur Terminologie:
Unter einer Verbindung wird hierin generell eine mechanische Verbindung des Telematik-Moduls mit der glatten Oberfläche des zu überwachenden Gegenstandes verstanden.
Unter den Telematikmoduldaten werden hierin generell eine oder mehrere Informationen verstanden, die digitalisiert als die Telematikmoduldaten übertragen werden.
Unter den Beschreibungen dicht oder Dichtigkeit werden jeweils luftdicht oder eine Dichtigkeit gegen Luft verstanden.
Unter dem "Saugnapf" wird ein Mittel mit einer Form verstanden, die einen Hohlraum aufweist, der nach außen hin offen ist, wobei eine Öffnung des Hohlraums, um nach außen offen zu sein, eine Fläche bildet. Dabei weist der Saugnapf entlang der Öffnung die Saugnapflippe auf, die zumindest entlang des äußeren Randes elastisch ist, um bei einem leichten Anpressen an die Oberfläche des zu überwachenden Gegenstandes gegen diese eine Dichtigkeit herstellen zu können.
Unter dem Unterdruck wird ein Unterdruck gegenüber der Atmosphäre verstanden.
Unter dem Begriff "Andrücken" wird ein leichtes Anpressen des Saugnapfs an der Oberfläche, mit dem er verbunden werden soll, verstanden, so dass bevorzugt eine Luft, die sich noch im Saugnapf befindet, herausgedrückt werden kann und zugleich eine Dichtigkeit zur Erzeugung des Unterdrucks im Saugnapf und gegen die Oberfläche entsteht.
Unter einem Drucksignal wird im jeweiligen Kontext mit dem Detektor ein Drucksignalwert verstanden.

Weitere bevorzugte und vorteilhafte Merkmale und Vorteile der Erfindung werden durch die Ansprüche und/oder durch die detaillierte Beschreibung der bevorzugten Ausführungsform offenbart.

Eine bevorzugte Ausführungsform gemäß der vorliegenden Erfindung ist in nachfolgenden Zeichnungen und in einer detaillierten Beschreibung dargestellt, soll aber die vorliegende Erfindung nicht darauf begrenzen.

### Kurzbeschreibung der Zeichnungen

Fig. 1 zeigt schematisch in Seitenansicht eine bevorzugte Telematik-Vorrichtung, die ein Telematik-Modul umfasst, das einerseits über eine Saugnapfverbindung mit einer Oberfläche eines zu überwachenden Gegenstandes verbunden ist und andererseits über eine Funkverbindung mit einer Überwachungsstation kommuniziert.
Fig. 2 zeigt schematisch in Seitenansicht eine weitere bevorzugte Telematik-Vorrichtung ähnlich der aus Fig. 1, wobei die Funkverbindung des Telematik-Moduls mit der Überwachungsstation jedoch über ein zusätzlich in der Telematik-Vorrichtung eingebundenes Datenfunkgerät geschieht, das Daten vom Telematik-Modul empfängt und weitersendet an die Überwachungsstation. Dabei kann das Datenfunkgerät zusätzlich Sensorsignale empfangen und weiterleiten.
Fig. 3 zeigt in perspektivischer Ansicht das Telematik-Modul von unten von einer Saugnapfseite her gesehen, wobei in einer Mitte des Saugnapfs eine Solarzelle angeordnet ist.
Fig. 4 zeigt in Seitenansicht das bevorzugte an der Oberfläche angesaugte Telematik-Modul mit diversen, möglichen Sensorkomponenten und anderen Komponenten.
Fig. 5 zeigt in Seitenansicht eine weitere bevorzugte Ausführungsform des Saugnapfs mit darin angeordnetem Gehäuse des Telematik-Moduls.
Fig. 6 zeigt in Seitenansicht eine weitere bevorzugte Ausführungsform des Telematik-Moduls, wobei im Innern des Saugnapfs Saugnapfabstandshalter zwischen einem Gehäuse des Telematik-Moduls und der Oberfläche angeordnet sind.

### Detaillierte Beschreibung einer bevorzugten Ausführungsform

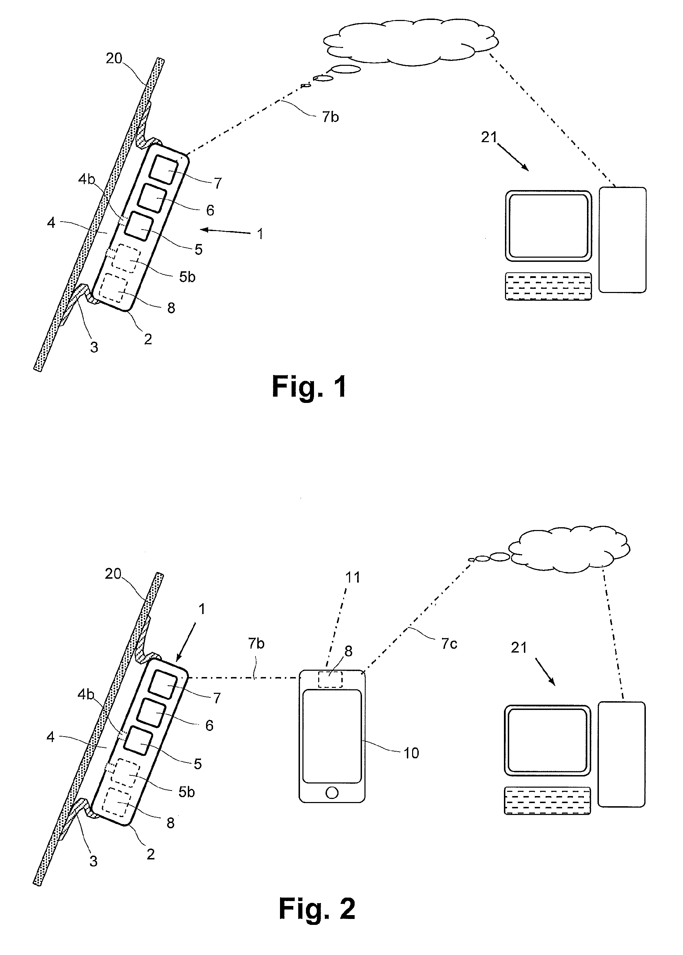

In Fig. 1 ist eine bevorzugte Telematik-Vorrichtung als ein Telematik-Modul 1 dargestellt, wobei das Telematik-Modul 1 einen Saugnapf 3 umfasst, um über den Saugnapf 3 mit einer glatten Oberfläche 20 eines zu überwachenden Gegenstandes wiederholt verbunden und davon ebenso leicht wieder gelöst werden zu können. Allgemein kann der zu überwachende Gegenstand beispielsweise ein Automobil oder ein anderes Fahrzeug sein, das mit dem Telematik-Modul 1 zuverlässig überwacht werden soll. Die glatte Oberfläche 20 ist dabei beispielsweise eine Windschutzscheibe, eine sonstige Fensterscheibe oder aber auch jede andere glatte Oberfläche 20, die sich eignet, um darauf den Saugnapf 3 durch einen Unterdruck im Saugnapf 3 dicht ansaugen lassen zu können.

Das Telematik-Modul 1 steht über eine Funkverbindung 7b mit einer Überwachungsstation 21 in Funkverbindung, wobei Information als Telematikmoduldaten zur Überwachungsstation 21 übertragen wird. Bevorzugt werden durch das Telematik-Modul 1 Sensordaten übermittelt, um die Sensordaten und damit einen Zustand des zu überwachenden Gegenstandes an der Überwachungsstation 21 überwachen zu können. Die Funkverbindung 7b kann auf dem Weg zur Überwachungsstation 21 ebenso eine oder mehrere, weitere Funkverbindungen, eine drahtgebundene Datenverbindung, das Internet und/oder dergleichen umfassen. Bevorzugt ist die Funkverbindung 7b eine Langstrecken-Funkverbindung, basierend auf GSM, GPRS, EDGE, HSxPA, UMTS, LTE, CDMA oder dergleichen. Alternativ kann die Funkverbindung 7b auch eine Kurzstrecken-Funkverbindung sein, beispielsweise basierend auf einem Standard wie Bluetooth, Zigbee oder dergleichen. Bevorzugt ist die Funkverbindung 7b eine übliche M2M Funkverbindung, die Information über SMS oder TCP/IP austauscht.

Unter der zuverlässigen Überwachung des Automobils oder des zu überwachenden Gegenstandes, im Allgemeinen, wird verstanden, dass das Telematik-Modul 1, wenn es einmal mit dem zu überwachenden Gegenstand über den Saugnapf 3 verbunden ist, auch in dauernder mechanischer Verbindung steht und nicht einfach vom zu überwachenden Gegenstand abmontiert oder davon losgelöst werden kann, ohne dass das Lösen der Verbindung oder ein Abmontieren der Überwachungsstation 21 als Information über die Telematikmoduldaten mitgeteilt würde. In anderen Worten wird zuverlässig sichergestellt, dass das Telematik-Modul 1 mit dem zu überwachenden Gegenstand verbunden ist und die Telematikmoduldaten tatsächlich vom Ort des zu überwachenden Gegenstandes stammen. Andernfalls, wenn die Verbindung zwischen dem Telematik-Modul 1 und dem zu überwachenden Gegenstand gelöst worden ist, wird das Lösen detektiert, gespeichert und an das Überwachungsstation als Information übertragen.

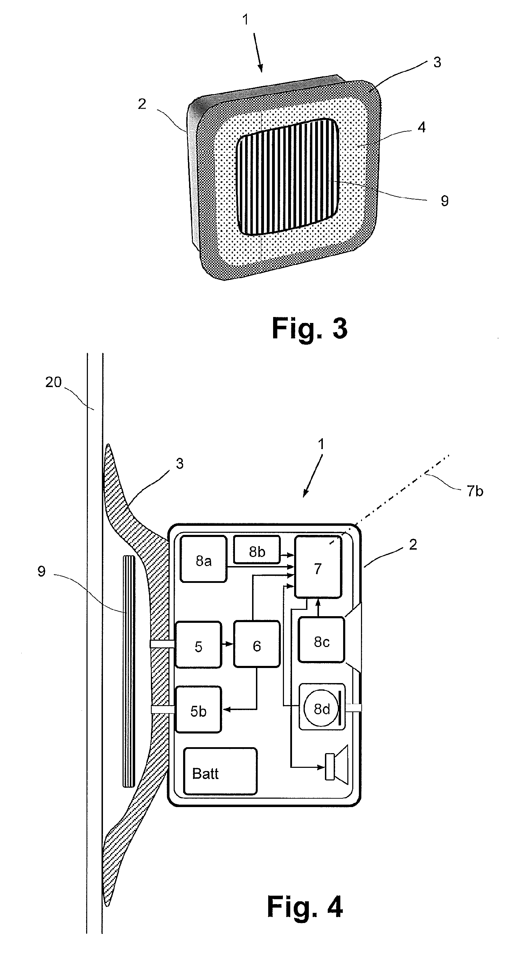

Das Telematik-Modul 1 ist im vorliegenden Beispiel als ein Gerät aufgebaut, das ein Gehäuse 2 mit einer Elektronik umfasst, wobei am Gehäuse 2 an dessen Unterseite der Saugnapf 3 angeordnet ist. Der Saugnapf 3 ist im vorliegenden Beispiel im Wesentlichen aus einer umlaufenden Saugnapflippe aufgebaut, die zusammen mit der Unterseite des Gehäuses 2 dicht abschließt und so den Saugnapf 3 bildet. Bevorzugt ist der Saugnapf 3 mit dem Gehäuse 2 fest durch eine Klebe-, Schweiß- oder Klemmverbindung verbunden. Ebenso ist es denkbar, dass der Saugnapf 3 mit dem Gehäuse 2 nur so verbunden ist, indem die jeweiligen aneinanderstoßenden Grenzflächen eine luftdichte Verbindung miteinander eingehen. Alternativ kann der Saugnapf 3 ebenso auch wie in Fig. 4 ausgebildet sein, wobei der Saugnapf 3 eine integrale Einheit bildet und als solche mit dem Gehäuse 2 verbunden ist. Die Saugnapflippe ist so ausgebildet, dass sie an der äußeren, der Oberfläche 20 zugewandten Seite an die Oberfläche 20 des zu überwachenden Gegenstandes angepasst ist, die beispielsweise einen ebenen oder einen gekrümmten Querschnitt ausweist. Bevorzugt ist die Saugnapflippe elastisch und flexibel ausgebildet, so dass sie sich möglichen Unebenheiten der Oberfläche 20 anpassen kann. Der Saugnapf 3 mit der umlaufenden Saugnapflippe ist so ausgebildet, das er nach einem Anpressen auf der Oberfläche 20 über dieser einen Hohlraum 4 bildet. Durch den Hohlraum 4 und den darin erzeugten Unterdruck wird ein Ansaugen an die Oberfläche 20 und damit die Verbindung des Telematik-Moduls 1 mit der Oberfläche 20 bewirkt. Zur Verbindung wird ein bestimmter Halte-Unterdruck erzeugt.

Bevorzugt ist der Saugnapf 3 und/oder die Saugnapflippe so elastisch und flexibel ausgebildet, um bei einem Andrücken des Telematik-Moduls 1 an die Oberfläche 20 soweit elastisch nachzugeben, dass sich der innere Hohlraum 4 verkleinert, eine Luft dabei herausdrückt und bei einem Rückgang in die ursprüngliche Lage den Unterdruck erzeugt. Alternativ kann der Saugnapf auch weniger elastisch ausgebildet sein, wobei der Unterdruck durch eine Vakuumpumpe 5b erzeugt wird, der mit dem Hohlraum 4 über einen Druckkanal in Verbindung steht.

Generell umfasst die Elektronik einen Mikroprozessor mit einer Ablaufsteuerung, ein Funkmodul 7 zur Herstellung der Funkverbindung 7b und erfindungsgemäß einen Drucksensor 5, der bevorzugt über einen Druckkanal 4b mit dem Hohlraum 4 in Verbindung steht und ein entsprechendes Drucksignal erzeugt, und einen Detektor 6 zur Überwachung des Drucksignals oder des Drucksignalverlaufs. Der Detektor 6 ist bevorzugt in der Ablaufsteuerung des Mikroprozessors implementiert, er kann aber auch ebenso als ein separater Detektor 6 vorliegen.

Der Detektor ist dabei ausgebildet, eine Änderung des aktuellen Drucksignals gegenüber einem vorher abgespeicherten Drucksignal zu bestimmen und mit mindestens einem Schwellwert zu vergleichen. Dabei ist das vorher abgespeicherte Drucksignal bevorzugt ein Wert unmittelbar nach einem eingeschwungenen Zustand nach Erreichen des Halte-Unterdrucks. Alternativ kann das vorher abgespeicherte Drucksignal auch einem Wert vor einem bestimmten Zeitintervall entsprechen. Eine Bestimmung der Drucksignaländerung kann sowohl analog als auch digital vorgenommen werden. Bei Erkennen einer Überschreitung des mindestens einen Schwellwerts durch die Drucksignaländerung vom Detektor 6 erzeugt die Elektronik ein Alarmsignal. Der mindestens eine Schwellwert ist dabei für das unerlaubte Lösen des Telematik-Moduls 1 von der Oberfläche 20 charakteristisch, von der Drucksignaländerung überschritten zu werden, und er wird als solcher im Detektor abgespeichert. Unter "abgespeichert" wird verstanden, dass der Schwellwert in Hardware als eine analoge Spannung oder als ein Widerstandswert oder in Software als digitaler Wert in einem Speicher abgebildet ist. Bevorzugt ist der Detektor 6 ausgebildet mindestens einen typischen Drucksignalverlauf zu erkennen, der typisch für ein unerlaubtes Lösen der Verbindung ist. Ergänzend wird festgestellt, dass vom Detektor 6 eine Erkennung des Lösens der Verbindung auch dadurch detektiert werden kann, indem anstelle der Drucksignaldifferenz aus dem vorher abgespeicherten und dem aktuellen Drucksignal nunmehr ein Drucksignalquotient gebildet und mit mindestens einem entsprechenden Schwellwert verglichen wird. Beide Erkennungen aus der Drucksignaldifferenz und dem Drucksignalquotient können auch kombiniert werden.

Nach einer Erkennung des Überschreitens des mindestens einen Schwellwerts wird dieser Zustand als das Alarmsignal gespeichert und daraufhin mit den Telematikmoduldaten übertragen. Bevorzugt wird das Alarmsignal oder die Information dazu solange mit den Telematikmoduldaten übertragen, bis diese Information an der Überwachungsstation 21 angekommen ist und von dieser bestätigt wird. Ein zeitweises Abreißen der Funkverbindung 7b zur Überwachungsstation 21 bewirkt dabei keinen Verlust der zu übertragenen Information des Alarmsignals. Auf diese Weise wird sichergestellt, dass die Verbindung zwischen dem Telematik-Modul 1 und dem zu überwachenden Gegenstand zuverlässig überwacht wird.

Bevorzugt umfasst der Detektor 6 eine Vielzahl von Schwellwerten, gegen die das Drucksignal und/oder die Drucksignaländerung verglichen werden. Die unterschiedlichen Schwellwerte stellen dabei bestimmte Druckwerte oder Druckänderungen dar, die jeweils charakteristisch sind, bei unterschiedlichen Arten des unerlaubten Lösens des Telematik-Moduls 1 von der Oberfläche 20 überschritten zu werden.

Bevorzugt ist der Detektor 6 ausgebildet, sowohl einen Druckabfall als auch einen Druckanstieg des Unterdrucks mit dem jeweiligen Schwellwert zu vergleichen. Bevorzugt ist der Detektor 6 bei der Bestimmung der Drucksignaländerung ausgebildet, ein oder mehrere Zeitintervalle zu berücksichtigen. Ebenso denkbar ist ein Detektor 6, der auf Mustererkennungsalgorithmen basiert, um das Lösen der Verbindung zuverlässig zu detektieren. Dabei sind bevorzugt Fälle des unerlaubten Lösens zu detektieren, bei denen beispielsweise der Saugnapf 3 von außen durchstochen wird, um das Vakuum sehr langsam abzulassen und Luft einströmen zu lassen. Es kann aber auch der Fall eines unerlaubten Lösens vorliegen, indem von außen um das Telematik-Modul 1 herum und gegen die Oberfläche 20 ein zweites Vakuum aufgebracht wird, um das Telematik-Modul 1 abfallen zu lassen, wenn das zweite Vakuum größer ist als der Unterdruck im Hohlraum 4.

Bevorzugt umfasst die Elektronik zudem eine Sensorik 8 mit mindestens einem Sensor und entsprechender Ankoppelschaltung an den Detektor oder an das Funkmodul 7. Dabei liefert die Sensorik 8 Messdaten im Bereich des Telematik-Moduls 1, wobei die Messdaten entweder vorverarbeitet oder nicht vorverarbeitet über die Telematikmoduldaten weitergeleitet werden. Bevorzugt umfasst die Sensorik 8 dabei einen Beschleunigungssensor 8a, der Beschleunigungswerte in die Messdaten umwandelt. Bevorzugt umfasst die Sensorik 8 zudem oder alternativ einen Körperschallsensor und/oder ein Mikrofon 8d, um das entsprechende Meßsignal dabei zu erzeugen. Bevorzugt umfasst die Sensorik 8 zudem oder alternativ einen Positionssensor 8b auf Basis GPS, Galileo oder auf einer anderen Basis. Bevorzugt umfasst die Sensorik 8 einen Feuchtesensor und/oder einen Temperatursensor.

Bevorzugt umfasst das Telematik-Modul 1 zudem die Vakuumpumpe 5b, die über den weiteren Druckkanal mit dem Hohlraum 4 verbunden und durch die Elektronik ansteuerbar ist. Bevorzugt umfasst die Elektronik eine weitere Detektorschwelle und/oder einen weiteren Detektor, um im Drucksignal des Drucksensors 5 zu detektieren wann der Unterdruck im Hohlraum 4 einen bestimmten Halte-Unterdruck erreicht hat, um bis dahin die Vakuumpumpe 5b aktivierend anzusteuern. Alternativ kann die Ansteuerung der Vakuumpumpe 5b und das Erreichen des Halte-Unterdrucks auch anders bestimmt werden, wie beispielsweise durch einen Näherungsschalter zur Oberfläche 20 oder durch einen Anschlagschalter. Dabei ist der Halte-Unterdruck eine Größe, die gerade so groß ist, dass das Telematik-Modul 1 trotz aufgebrachter Beschleunigungen zuverlässig an der Oberfläche 20 haften bleibt.

Bevorzugt umfasst die Elektronik einen Pumpenansteuerdetektor, der bei einem Abfall des Unterdrucks unten einen abgespeicherten Unterdruck-Schwellwert die Vakuumpumpe 5b ansteuert.

Bevorzugt berücksichtigt der Detektor 6 während der Ansteuerung der Vakuumpumpe 5b die Erzeugung des weiteren Unterdrucks bei einer Schwellwertanalyse oder bei der Erkennung der Überschreitung des Drucksignals gegen die Schwellwerte, um bei einem Anstieg des Unterdrucks keine Fehlerkennung des Lösens und damit ein fehlerhaftes Alarmsignal zu erzeugen. Bevorzugt berücksichtigt der Detektor 6 während der Ansteuerung der Vakuumpumpe 5b die Erzeugung des weiteren Unterdrucks so, indem der typische Anstieg des Unterdrucks durch die Vakuumpumpe 5b vom jeweiligen Schwellwert des Detektors 6 abgezogen oder zum jeweiligen Schwellwert hinzuaddiert wird.

Bevorzugt ist die Elektronik ausgebildet, die Verbindung des Telematik-Moduls 1 mit der Oberfläche 20 durch die Ansteuerung der Vakuumpumpe 5b zur Erzeugung des Unterdrucks vorzunehmen.

Bevorzugt erkennt der Detektor 6 einen positiven Druckanstieg des Drucksignals von Null auf über einen Anpress-Schwellwert, um daraufhin eine Funktion zu starten, wobei der Anpress-Schwellwert einem Druck entspricht, der typischerweise bei einem leichten Andrücken oder Anpressen des Telematik-Moduls 1 gegen die Oberfläche 20 und einem elastischen Nachgeben des Saugnapfs 3 gerade überschritten wird.

Bevorzugt besteht die gestartete Funktion dabei in der Ansteuerung der Vakuumpumpe 5b zur Erzeugung des Unterdrucks bis zum Halte-Unterdruck für die Verbindung des Telematik-Moduls 1 mit der Oberfläche 20. Zudem oder alternativ besteht die gestartete Funktion in einer Aktivierung der Elektronik von einem Ruhezustand mit lediglich aktivem Drucksensor in einen aktiveren Zustand mit aktiviertem Funkmodul 7. Zudem oder alternativ besteht die gestartete Funktion in einer Aktivierung eines weiteren Sensors oder einer Sensorfunktion.

Bevorzugt umfasst das Telematik-Modul 1 zudem ein Kameramodul 8c, das Bilddaten erzeugt, die über die Telematikmoduldaten übertragen werden. Dabei ist das Kameramodul 8c entweder in Richtung der Unterseite des Gehäuses 2 oder in Richtung der Oberseite des Gehäuses 2 ausgerichtet.

Bevorzugt umfasst das Telematik-Modul 1 zudem ein Solarzellenmodul 9, das im Saugnapf nach außen hin gerichtet angeordnet ist, siehe dazu Fig. 3. Dabei ist das Solarzellenmodul 9 im Saugnapf so angeordnet, dass es bei einer Ankopplung des Telematik-Moduls 1 an der Oberfläche 20, die in diesem Fall eine Scheibe ist, nach außen gerichtet ist. Dabei empfängt das Solarzellenmodul 9 Licht, das von außen durch die Scheibe ins Innere des Saugnapfs, wo sich das Solarzellenmodul 9 befindet, hinein gestrahlt wird und wandelt Lichtenergie in elektrische Energie um, um dann zum Laden einem Energiespeicher zugeführt zu werden.

Bevorzugt umfasst das Telematik-Modul 1 zudem einen weiteren Detektor, der ausgebildet ist, mindestens ein Meßsignal der Sensorik so zu verarbeiten, um darin ein Geräusch und/oder eine Vibration zu erkennen. Bei einem Erkennen des Geräuschs und/oder der Vibration durch ein Überschreiten eines entsprechenden Schwellwerts, wird eine anderes Alarmsignal erzeugt und über die Telematikmoduldaten übermittelt.

Bevorzugt ist im Inneren des Saugnapfs 3 zwischen der Unterseite des Gehäuses 2 und in orthogonaler Richtung zur Ebene der umlaufenden Saugnapflippe mindestens ein Saugnapfabstandshalter 3b angeordnet, der eine Höhe aufweist, um beim Ansaugen des Saugnapfs 3 an die Oberfläche 20 ab einem Anstoß-Unterdruck an der Oberfläche 20 anzustoßen und bei einem weiteren Ansteigen des Unterdrucks den Abstand zwischen dem Telematik-Modul 1 und der Oberfläche 20 konstant zu halten. Bevorzugt ist der Halte-Unterdruck größer als der Anstoß-Unterdruck bemessen, so dass es bei Beschleunigungen bis zu bestimmten Grenzwerten in x/y-z-Richtung zu keinen Veränderungen des Volumens des Hohlraums 4 kommt und dadurch auch keine Druckschwankungen entstehen. Auf diese Weise kann eine fehlerhafte Erkennung eines Lösens der Verbindung verhindert werden. Dadurch führen auch eine Vibration oder Vibrationsbeschleunigungen zu keiner Änderung des Drucksignals.

Bevorzugt ist der zu überwachende Gegenstand ein Kraftfahrzeug, ein Lastkraftwagen, ein Baufahrzeug oder ein anderes Fahrzeug.

Eine weitere bevorzugte Ausführungsform ist in Fig. 2 dargestellt, bei der die Telematik-Vorrichtung zusätzlich zum Telematik-Modul 1 ein davon abgesetztes, zusätzliches Datenfunkgerät 10 umfasst, das mit dem Telematik-Modul 1 über die Funkverbindung 7b kommuniziert. Die Funkverbindung 7b ist dabei als Kurzstrecken-Funkverbindung ausgelegt, wobei das Funkmodul 7 und das korrespondierende Funkmodul im Datenfunkgerät 10 jeweils als Kurzstrecken-Funkmodul ausgebildet sind. Das Kurzstrecken-Funkmodul hat bevorzugt eine Reichweite von ca. 10m oder ca. 100m oder ca. 300m. Größere Reichweiten bis 1000m sind dabei auch denkbar. Dabei werden die Telematikmoduldaten vom Telematik-Modul 1 zum Datenfunkgerät 10 übertragen.

Das Datenfunkgerät 10 umfasst dabei ein Langstrecken-Funkmodul, um damit mit der Überwachungsstation 21 zu kommunizieren und an diese zumindest einen Teil der Telematikmoduldaten weiterzuleiten. Das Langstrecken-Funkmodul basiert dabei auf einem Mobilfunkstandard wie GSM, GPRS, EDGE, HSDPA, HSUPA, UMTS, LTE, CDMA oder einem anderen vergleichbaren Mobilfunkstandard.

Bevorzugt wird als Datenfunkgerät 10 ein Mobilfunkgerät verwendet, das mit einer entsprechenden Applikation für die Datenverarbeitung der Telematikmoduldaten und Weiterleitung zur Überwachungsstation 21 ausgestattet ist.

Bevorzugt umfasst das Datenfunkgerät 10 eine weitere Sensorik und einen Mikrokontroller, wobei das Datenfunkgerät 10 ausgebildet ist, Sensorsignale der weiteren Sensorik entweder vorverarbeitet oder nicht vorverarbeitet zur Überwachungsstation 21 zu senden.

Bevorzugt beruht die Funkverbindung zwischen dem Kurzstrecken-Funkmodul des Datenfunkgeräts 10 und dem Funkmodul 7 des Telematik-Moduls 1 auf einer authentifizierten und/oder einer verschlüsselten Verbindung.

In Fig. 3 ist das Telematik-Modul 1 von unten mit dem Solarzellenmodul 9 dargestellt, das im Inneren des Saugnapfs 3 angeordnet ist und mit der lichtempfindlichen Seite nach außen zur Ebene der umlaufenden Saugnapflippe hin ausgerichtet ist.

In Fig. 4 ist das Telematik-Modul 1 mit dem Saugnapf 3 von der Seite als Querschnitt dargestellt. Fig. 4 zeigt eine bevorzugte Anordnung des Drucksensors 5, der Vakuumpumpe 5b, des Detektors 6 und des Funkmoduls 7. Zudem sind im dargestellten Telematik-Modul 1 der Beschleunigungssensor 8a, der Positionssensor 8b, das Kameramodul 8c und das Mikrofon 8d als bevorzugte Sensoren dargestellt. Zudem ist im Telematik-Modul 1 bevorzugt ein Lautsprecher angeordnet, um Signale auszugeben und/oder eine Sprachübermittlung über das Funkmodul 7 zu ermöglichen. Als die Energiequelle für das Telematik-Modul 1 ist eine Batterie oder ein Akkumulator Batt darin angeordnet. Bevorzugt umfasst das Telematik-Modul 1 eine Ladeschaltung zur Aufladung des Akkumulators Batt durch das Solarzellenmodul 9 und/oder durch eine von außen zugeführte elektrische Energie. In Fig. 4 ist der Saugnapf 3 als ein geschlossener, integraler Saugnapf 3 dargestellt, der mit dem Gehäuse 2 des Telematik-Moduls 1 fest verbunden ist. Alternativ dazu kann der Saugnapf 3 aber ebenso gut aus verschiedenen Teilen zusammengesetzt sein. In Fig. 1 ist beispielsweise ein Saugnapf 3 dargestellt, der aus einer Saugnapflippe in dichter Verbindung mit dem Gehäuse 2 besteht.

Bevorzugt kann die Elektronik des Telematik-Moduls 1 ausgebildet sein, auch ein Aufladen über eine Induktionsantenne zu umfassen.

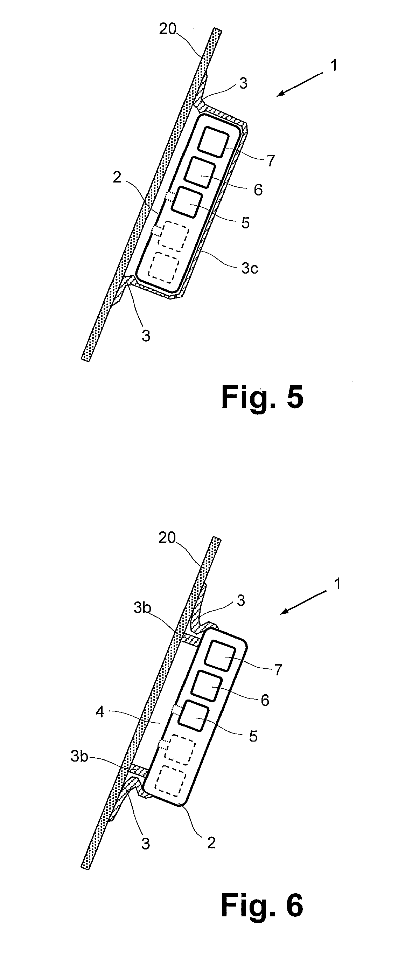

Ebenso könnte der Saugnapf gemäß Fig. 5 ausgebildet sein, wobei ein oberes Teil 3c des Saugnapfs 3, das der Saugnapflippe gegenüber angeordnet ist, sich über das gesamte Gehäuse 2 hin erstreckt, um eine Oberseite des Gehäuses 2, die der Unterseite gegenüberliegt, durch das obere Teil 3c des Saugnapfs 3 zu bedecken. Das Gehäuse 2 ist damit bevorzugt insgesamt im Hohlraum 4 angeordnet.

In Fig. 6 ist das bevorzugte Telematik-Modul 1 mit dem Saugnapf 3 und mit den bevorzugten Saugnapfabstandshaltern 3b in einer Seitenansicht dargestellt.

Bevorzugt kann die Elektronik des Telematik-Moduls 1 ausgebildet sein, auch eine Spracherkennung zu umfassen.

Bevorzugt kann die Elektronik des Telematik-Moduls 1 ausgebildet sein, auch eine Richtungsanzeige für Navigation zu umfassen.

Ein erfindungsgemäßes Verfahren zur Erkennung des unerlaubten Lösens der Verbindung zwischen dem Telematik-Modul 1 und der glatten Oberfläche 20 des zu überwachenden Gegenstandes,
wobei das Telematik-Modul 1 das Gehäuse 2 mit dem Saugnapf 3 aufweist und mit dem zu überwachenden Gegenstand über den Saugnapf 3 so verbindbar ist, dass der Saugnapf 3 luftdicht an der glatten Oberfläche 20 anliegt und in seinem Inneren den Hohlraum 4 bildet, der zur Oberfläche 20 hin offen ist, um im Hohlraum 4 den Unterdruck gegenüber der Atmosphäre bilden zu können, der die Verbindung zwischen dem Saug napf 3 und der Oberfläche 20 herstellt;
umfasst folgende Schritte:
- Anordnen des Drucksensors 5 im Telematik-Modul 1, so dass er mit dem Hohlraum 4 in Verbindung steht und ein entsprechendes Drucksignal erzeugt;
- Anordnen des Detektors 6 im Telematik-Modul 1, in dem mindestens ein Schwellwert zu einer Drucksignaländerung abgespeichert ist, die typisch ist, überschritten zu werden, wenn das unerlaubte Lösen der Verbindung vorliegt;
- Abspeichern eines ersten Drucksignalwerts und Bestimmen aus einem nachfolgenden, zweiten Drucksignalwert eine Drucksignaländerung;
- Vergleichen der Drucksignaländerung mit dem mindestens einen Schwellwert, wobei, wenn eine Überschreitung des mindestens einen Schwellwerts erkannt wird, das Lösen der Verbindung erkannt und ein Alarmsignal erzeugt und abgespeichert wird; und
- Übermitteln des Alarmsignals zu einer Überwachungsstation 21.

Weitere mögliche Ausbildungsformen oder Verfahrensschritte sind in den folgenden Ansprüchen beschrieben. Insbesondere können auch die verschiedenen Merkmale der oben beschriebenen Ausführungsformen miteinander kombiniert werden, soweit sie sich nicht technisch ausschließen.

Die In den Ansprüchen genannten Bezugszeichen dienen der besseren Verständlichkeit, beschränken aber die Ansprüche nicht auf die in den Figuren dargestellten Formen.

### Bezugszeichenliste

- 1: Telematik Modul
- 2: Gehäuse
- 3: Saugnapf
- 3b: Saugnapfabstandshalter
- 3c: oberes Teil des Saugnapfs 3
- 4: Hohlraum
- 4b: Druckkanal
- 5: Drucksensor
- 5b: Vakuumpumpe
- 6: Detektor
- 7: Funkmodul
- 7b: Funkverbindung
- 7c: weitere Funkverbindung
- 8: Sensorik
- 8a: Beschleunigungssensor
- 8b: Positionssensor
- 8c: Kameramodul
- 8d: Mikrofon
- 9: Solarzellenmodul
- 10: Datenfunkgerät
- 11: GPS Signal
- 20: glatte Oberfläche
- 21: Überwachungsstation
- Batt: Batterie/Akkumuklator

## Patentansprüche

1. Telematik-Vorrichtung, umfassend ein Telematik-Modul (1) mit einem Saugnapf (3) zur Verbindung mit einer glatten Oberfläche (20) eines zu überwachenden Gegenstandes, wobei ein Lösen der Verbindung erkannt und ein Alarmsignal ausgelöst wird, das Telematik-Modul (1) umfassend:
- eine Elektronik mit einem Mikroprozessor mit Ablaufsteuerung und einem Funkmodul (7) zur drahtlosen Übertragung von Telematikmoduldaten zu einer Überwachungsstation (21);
- ein Gehäuse (2), in der die Elektronik untergebracht ist;
- den Saugnapf (3), der mit dem Gehäuse (2) verbunden und so ausgebildet ist, an einer Unterseite des Gehäuses (2) nach außen hin eine überstehende, umlaufende Saugnapflippe aufzuweisen, die sich bei einem Andrücken auf der glatten Oberfläche (20) an diese anpasst und mit dieser dicht abschließt, wobei in einem Innern zwischen der umlaufenden Saugnapflippe und zur Oberfläche (20) hin offen ein Hohlraum (4) ausgebildet ist, um bei einem Unterdruck im Hohlraum (4) ein Ansaugen an die Oberfläche (20) und damit die Verbindung des Telematik-Moduls (1) zu bewirken; **dadurch gekennzeichnet, dass**
- die Elektronik einen Drucksensor (5) umfasst, der mit dem Hohlraum (4) des Saugnapfs (3) verbunden ist und ein entsprechendes Drucksignal erzeugt;
- die Elektronik einen Detektor (6) zur Überwachung des Drucksignals umfasst, der ausgebildet ist, eine Drucksignaländerung zu bestimmen und mit mindestens einem Schwellwert zu vergleichen, um bei einer Überschreitung des mindestens einen Schwellwerts das Lösen der Verbindung zu erkennen und daraufhin das Alarmsignal zu erzeugen, wobei der mindestens eine Schwellwert charakteristisch für ein unerlaubtes Lösen des Telematik-Moduls (1) von der Oberfläche (20) ist und im Detektor abgespeichert ist; und
- die Elektronik das Alarmsignal speichert und daraufhin mit den Telematikmoduldaten zur Überwachungsstation (21) überträgt.

2. Telematik-Vorrichtung gemäß Anspruch 1, wobei der Detektor (6) eine Vielzahl von Schwellwerten umfasst, gegen die das Drucksignal und/oder die Drucksignaländerung verglichen werden, wobei die Schwellwerte Druckwerte und/oder Druckänderungen darstellen, die jeweils charakteristisch sind, bei unterschiedlichen Arten des unerlaubten Lösens der Verbindung zwischen dem Telematik-Modul (1) und der Oberfläche (20) überschritten zu werden.

3. Telematik-Vorrichtung gemäß Anspruch 1 oder 2, wobei die Elektronik zudem eine Sensorik (8) mit mindestens einem Sensor umfasst und die Sensorik Messdaten liefert, die vorverarbeitet oder nicht vorverarbeitet über die Telematikmoduldaten weitergeleitet werden,
wobei der mindestens eine Sensor ein Beschleunigungssensor (8a), ein Körperschallsensor, ein Mikrofon (8d) oder ein Positionssensor (8b) auf Basis GPS, Galileo oder auf einer anderen Basis ist.

4. Telematik-Vorrichtung gemäß einem oder mehreren der vorstehenden Ansprüche, wobei das Telematik-Modul (1) zudem eine Vakuumpumpe (5b) umfasst, die mit dem Hohlraum (4) verbunden und durch die Elektronik ansteuerbar ist, um dadurch einen weiteren Unterdruck im Hohlraum (4) des Saugnapfs (3) zu erzeugen.

5. Telematik-Vorrichtung gemäß Anspruch 4, wobei die Elektronik zudem einen Pumpenansteuerdetektor umfasst, der bei einem Abfall des Unterdrucks unten einen abgespeicherten Unterdruck-Schwellwert die Vakuumpumpe (5b) ansteuert, und/oder
wobei der Detektor (6) während der Ansteuerung der Vakuumpumpe (5b) die Erzeugung des weiteren Unterdrucks bei einer Schwellwertanalyse des Drucksignals gegen die Schwellwerte berücksichtigt, so dass der Anstieg des Unterdrucks durch die Vakuumpumpe (5b) zu keiner Fehlerkennung des Lösens und zu keinem Alarmsignal führt, und/oder
wobei der Detektor (6) während der Ansteuerung der Vakuumpumpe (5b) die Erzeugung des weiteren Unterdrucks bei einer Schwellwertanalyse des Drucksignals gegen die Schwellwerte so berücksichtigt, dass der typischen Anstieg des Unterdrucks durch die Vakuumpumpe (5b) vom jeweiligen Schwellwert des Detektors (6) abgezogen oder hinzuaddiert wird, um dadurch keine Fehlerkennung des Lösens und ein Alarmsignal zu erzeugen, und/oder
wobei die Elektronik ausgebildet ist, die Verbindung des Telematik-Moduls (1) mit der Oberfläche (20) durch die Ansteuerung der Vakuumpumpe (5b) zur Erzeugung des Unterdrucks vorzunehmen.

6. Telematik-Vorrichtung gemäß Anspruch 4 oder 5, wobei der Detektor (6) einen positiven Druckanstieg des Drucksignals von Null auf über einen Anpress-Schwellwert erkennt und daraufhin eine Funktion startet, wobei der Anpress-Schweilwert so bemessen ist, dass er gerade unterhalb des typischen Druckwerts liegt, der bei einem ersten Andrücken des Telematik-Moduls (1) an die Oberfläche (20) entsteht; worauf
die aktivierte Funktion die Ansteuerung der Vakuumpumpe (5b) zur Erzeugung des Unterdrucks vornimmt, und/oder
die aktivierte Funktion die Elektronik von einem Ruhezustand mit lediglich aktivem Drucksensor in einen aktiveren Zustand mit aktiviertem Funkmodul (7) versetzt, und/oder
die aktivierte Funktion eine Sensorfunktion aktiviert.

7. Telematik-Vorrichtung gemäß einem oder mehreren der vorstehenden Ansprüche, wobei das Telematik-Modul (1) zudem ein Kameramodul (8c) umfasst, das Bilddaten erzeugt, die über die Telematikmoduldaten übertragen werden, wobei das Kameramodul (8c) entweder in Richtung der Unterseite des Gehäuses (2) oder in Richtung der Oberseite des Gehäuses (2) ausgerichtet ist.

8. Telematik-Vorrichtung gemäß einem oder mehreren der vorstehenden Ansprüche, wobei das Telematik-Modul (1) zudem ein Solarzellenmodul (9) umfasst, das im Saugnapf nach außen hin gerichtet angeordnet ist, so dass es bei einer Ankopplung des Telematik-Moduls (1) an einer Scheibe als der Oberfläche (20) nach außen durch die Scheibe gerichtet ist, um durch die Scheibe mit Licht bestrahlt werden zu können, wobei die Elektronik einen Strom des Solarzellenmodul (9) einem Energiespeicher zuführt.

9. Telematik-Vorrichtung gemäß Anspruch 2, wobei das Telematik-Modul (1) zudem einen weiteren Detektor umfasst, der ausgebildet ist, mindestens ein Meßsignal der Sensorik so zu verarbeiten, um darin ein Geräusch und/oder eine Vibration durch ein Überschreiten eines entsprechenden Schwellwerts zu erkennen und dabei ein anderes Alarmsignal zu erzeugen und über die Telematikmoduldaten zu übermitteln.

10. Telematik-Vorrichtung gemäß einem oder mehreren der vorstehenden Ansprüche, wobei in einem inneren Bereich des Saugnapfs (3) zwischen der Unterseite des Gehäuses (2) und in orthogonaler Richtung zur Ebene der umlaufenden Saugnapflippe mindestens ein Saugnapfabstandshalter (3b) angeordnet ist, der eine Höhe aufweist, die so bemessen ist, um beim Ansaugen des Saugnapfs (3) an die Oberfläche (20) ab einem Anstoß-Unterdruck an der Oberfläche (20) anzustoßen und bei einem weiteren Ansteigen des Unterdrucks den Abstand zwischen dem Telematik-Modul (1) und der Oberfläche (20) konstant zu halten.

11. Telematik-Vorrichtung gemäß einem oder mehreren der vorstehenden Ansprüche, wobei der zu überwachende Gegenstand ein Kraftfahrzeug, ein Lastkraftwagen, ein Baufahrzeug oder ein anderes Fahrzeug ist.

12. Telematik-Vorrichtung gemäß einem oder mehreren der vorstehenden Ansprüche, wobei das Funkmodul (7) als ein Kurzstrecken-Funkmodul ausgebildet ist, und die Telematik-Vorrichtung ein vom Telematik-Modul (1) abgesetztes zusätzliches Datenfunkgerät (10) umfasst, das ausgebildet ist,
- ein Kurzstrecken-Funkmodul aufzuweisen, um die Telematikmoduldaten vom Funkmodul (7) zu empfangen, und
- ein Langstrecken-Funkmodul aufzuweisen, um damit mit der Überwachungsstation (21) zu kommunizieren und an diese zumindest einen Teil der Telematikmoduldaten weiterzuleiten, wobei das Langstrecken-Funkmodul auf einem Mobilfunkstandard wie GSM, GPRS, EDGE, HSDPA, HSUPA, UMTS, LTE, CDMA oder einem anderen vergleichbaren Mobilfunkstandard basiert.

13. Telematik-Vorrichtung gemäß Anspruch 13, wobei das Datenfunkgerät (10) ein Mobilfunkgerät ist; und/oder
das Datenfunkgerät (10) eine weitere Sensorik und einen Mikrokontroller umfasst und ausgebildet ist, Sensorsignale der weiteren Sensorik vom Mikrokontroller vorverarbeitet oder nicht vorverarbeitet zur Überwachungsstation (21) zu senden.

14. Telematik-Vorrichtung gemäß einem oder mehreren der Ansprüche 13-14, wobei die Funkverbindung zwischen dem Kurzstrecken-Funkmodul des Datenfunkgeräts (10) und dem Funkmodul (7) des Telematik-Moduls (1) auf einer authentifizierten und/oder einer verschlüsselten Verbindung beruht.

15. Verfahren zur Erkennung eines unerlaubten Lösens einer Verbindung zwischen einem Telematik-Modul (1) und einer glatten Oberfläche (20) eines zu überwachenden Gegenstandes, wobei das Telematik-Modul (1) ein Gehäuse (2) mit einem Saugnapf (3) aufweist und mit dem zu überwachenden Gegenstand über den Saugnapf (3) so verbindbar ist, dass der Saugnapf (3) luftdicht an der glatten Oberfläche (20) anliegt und in seinem Inneren einen Hohlraum (4) bildet, der zur Oberfläche (20) hin offen ist, um im Hohlraum (4) einen Unterdruck gegenüber der Atmosphäre bilden zu können, der die Verbindung zwischen dem Saugnapf (3) und der Oberfläche (20) herstellt;
folgende Schritte umfassend:
- Anordnen eines Drucksensors (5) im Telematik-Modul (1), so dass er mit dem Hohlraum (4) in Verbindung steht und ein entsprechendes Drucksignal erzeugt;
- Anordnen eines Detektors (6) im Telematik-Modul (1), in dem mindestens ein Schwellwert zu einer Drucksignaländerung abgespeichert ist, die typisch ist, überschritten zu werden, wenn das unerlaubte Lösen der Verbindung vorliegt;
- Abspeichern eines ersten Drucksignalwerts und Bestimmen aus einem nachfolgenden, zweiten Drucksignalwert eine Drucksignaländerung;
- Vergleichen der Drucksignaländerung mit dem mindestens einen Schwellwert, wobei, wenn eine Überschreitung des mindestens einen Schwellwerts erkannt wird, das Lösen der Verbindung erkannt und ein Alarmsignal erzeugt und abgespeichert wird; und
- Übermitteln des Alarmsignals zu einer Überwachungsstation (21).

## Geänderte Patentansprüche

### Geänderte Patentansprüche gemäss Regel 137(2) EPÜ.

1. Telematik-Vorrichtung, umfassend ein Telematik-Modul (1) mit einem Saugnapf (3) zur Verbindung mit einer glatten Oberfläche (20) eines zu überwachenden Gegenstandes, wobei ein Lösen der Verbindung erkannt und ein Alarmsignal ausgelöst wird, das Telematik-Modul (1) umfassend:
a) eine Elektronik mit einem Mikroprozessor mit Ablaufsteuerung, mit einer Sensorik (8), die einen Beschleunigungssensor (8a) umfasst, und mit einem Funkmodul (7) zur drahtlosen Übertragung von Telematikmoduldaten zu einer Überwachungsstation (21), wobei die Telematikmoduldaten Messdaten der Sensorik (8) umfassen;
b) ein Gehäuse (2), in der die Elektronik untergebracht ist;
c) den Saugnapf (3), der mit dem Gehäuse (2) verbunden und so ausgebildet ist, an einer Unterseite des Gehäuses (2) nach außen hin eine überstehende, umlaufende Saugnapflippe aufzuweisen, die sich bei einem Andrücken auf der glatten Oberfläche (20) an diese anpasst und mit dieser dicht abschließt, wobei in einem Innern zwischen der umlaufenden Saugnapflippe und zur Oberfläche (20) hin offen ein Hohlraum (4) ausgebildet ist, um bei einem Unterdruck im Hohlraum (4) ein Ansaugen an die Oberfläche (20) und damit die Verbindung des Telematik-Moduls (1) zu bewirken;
d) einen Drucksensor (5), der mit dem Hohlraum (4) des Saugnapfs (3) verbunden ist, der Teil der Elektronik ist und ein entsprechendes Drucksignal erzeugt;
e) einen Detektor (6) als Teil der Elektronik (5) zur Überwachung des Drucksignals, der ausgebildet ist, eine Drucksignaländerung zu bestimmen und mit mindestens einem Schwellwert zu vergleichen, um bei einer Überschreitung des mindestens einen Schwellwerts das Lösen der Verbindung zu erkennen und daraufhin das Alarmsignal zu erzeugen, wobei der mindestens eine Schwellwert charakteristisch für ein unerlaubtes Lösen des Telematik-Moduls (1) von der Oberfläche (20) ist und im Detektor abgespeichert ist;
f) wobei die Elektronik das Alarmsignal speichert und daraufhin mit den Telematikmoduldaten zur Überwachungsstation (21) überträgt; und
g) das Funkmodul (7) als ein Kurzstrecken-Funkmodul ausgebildet ist;
h) ein zusätzliches Datenfunkgerät (10), das vom Telematik-Modul (1) abgesetzt und ausgebildet ist,
i) indem das Datenfunkgerät (10) ein Kurzstrecken-Funkmodul aufweist, um die Telematikmoduldaten vom Funkmodul (7) zu empfangen; und
j) indem das Datenfunkgerät (10) ein Langstrecken-Funkmodul aufweist, das auf einem Mobilfunkstandard wie GSM, GPRS, EDGE, HSDPA, HSUPA, UMTS, LTE, CDMA oder einem vergleichbaren Mobilfunkstandard basiert, um darüber mit der Überwachungsstation (21) zu kommunizieren, wobei an die Überwachungsstation (21) zumindest ein Teil der Telematikmoduldaten weitergeleitet wird.

2. Telematik-Vorrichtung gemäß Anspruch 1, wobei der Detektor (6) eine Vielzahl von Schwellwerten umfasst, gegen die das Drucksignal und/oder die Drucksignaländerung verglichen werden, wobei die Schwellwerte Druckwerte und/oder Druckänderungen darstellen, die jeweils charakteristisch sind, bei unterschiedlichen Arten des unerlaubten Lösens der Verbindung zwischen dem Telematik-Modul (1) und der Oberfläche (20) überschritten zu werden.

3. Telematik-Vorrichtung gemäß Anspruch 1 oder 2, wobei die Sensorik (8) zudem mindestens einen Körperschallsensor, ein Mikrofon (8d) oder einen Positionssensor (8b) auf Basis GPS, Galileo oder auf einer anderen Basis umfasst.

4. Telematik-Vorrichtung gemäß einem oder mehreren der vorstehenden Ansprüche, wobei das Telematik-Modul (1) zudem eine Vakuumpumpe (5b) umfasst, die mit dem Hohlraum (4) verbunden und durch die Elektronik ansteuerbar ist, um dadurch einen weiteren Unterdruck im Hohlraum (4) des Saugnapfs (3) zu erzeugen.

5. Telematik-Vorrichtung gemäß Anspruch 4, wobei die Elektronik zudem einen Pumpenansteuerdetektor umfasst, der bei einem Abfall des Unterdrucks unten einen abgespeicherten Unterdruck-Schwellwert die Vakuumpumpe (5b) ansteuert, und/oder
wobei der Detektor (6) während der Ansteuerung der Vakuumpumpe (5b) die Erzeugung des weiteren Unterdrucks bei einer Schwellwertanalyse des Drucksignals gegen die Schwellwerte berücksichtigt, so dass der Anstieg des Unterdrucks durch die Vakuumpumpe (5b) zu keiner Fehlerkennung des Lösens und zu keinem Alarmsignal führt, und/oder
wobei der Detektor (6) während der Ansteuerung der Vakuumpumpe (5b) die Erzeugung des weiteren Unterdrucks bei einer Schwellwertanalyse des Drucksignals gegen die Schwellwerte so berücksichtigt, dass der typischen Anstieg des Unterdrucks durch die Vakuumpumpe (5b) vom jeweiligen Schwellwert des Detektors (6) abgezogen oder hinzuaddiert wird, um dadurch keine Fehlerkennung des Lösens und ein Alarmsignal zu erzeugen, und/oder
wobei die Elektronik ausgebildet ist, die Verbindung des Telematik-Moduls (1) mit der Oberfläche (20) durch die Ansteuerung der Vakuumpumpe (5b) zur Erzeugung des Unterdrucks vorzunehmen.

6. Telematik-Vorrichtung gemäß Anspruch 4 oder 5, wobei der Detektor (6) einen positiven Druckanstieg des Drucksignals von Null auf über einen Anpress-Schwellwert erkennt und daraufhin eine Funktion startet, wobei der Anpress-Schwellwert so bemessen ist, dass er gerade unterhalb des typischen Druckwerts liegt, der bei einem ersten Andrücken des Telematik-Moduls (1) an die Oberfläche (20) entsteht; worauf
die aktivierte Funktion die Ansteuerung der Vakuumpumpe (5b) zur Erzeugung des Unterdrucks vornimmt, und/oder
die aktivierte Funktion die Elektronik von einem Ruhezustand mit lediglich aktivem Drucksensor in einen aktiveren Zustand mit aktiviertem Funkmodul (7) versetzt, und/oder
die aktivierte Funktion eine Sensorfunktion aktiviert.

7. Telematik-Vorrichtung gemäß einem oder mehreren der vorstehenden Ansprüche, wobei das Telematik-Modul (1) zudem ein Kameramodul (8c) umfasst, das Bilddaten erzeugt, die über die Telematikmoduldaten übertragen werden, wobei das Kameramodul (8c) entweder in Richtung der Unterseite des Gehäuses (2) oder in Richtung der Oberseite des Gehäuses (2) ausgerichtet ist.

8. Telematik-Vorrichtung gemäß einem oder mehreren der vorstehenden Ansprüche, wobei das Telematik-Modul (1) zudem ein Solarzellenmodul (9) umfasst, das im Saugnapf nach außen hin gerichtet angeordnet ist, so dass es bei einer Ankopplung des Telematik-Moduls (1) an einer Scheibe als der Oberfläche (20) nach außen durch die Scheibe gerichtet ist, um durch die Scheibe mit Licht bestrahlt werden zu können, wobei die Elektronik einen Strom des Solarzellenmodul (9) einem Energiespeicher zuführt.

9. Telematik-Vorrichtung gemäß Anspruch 2, wobei das Telematik-Modul (1) zudem einen weiteren Detektor umfasst, der ausgebildet ist, mindestens ein Meßsignal der Sensorik so zu verarbeiten, um darin ein Geräusch und/oder eine Vibration durch ein Überschreiten eines entsprechenden Schwellwerts zu erkennen und dabei ein anderes Alarmsignal zu erzeugen und über die Telematikmoduldaten zu übermitteln.

10. Telematik-Vorrichtung gemäß einem oder mehreren der vorstehenden Ansprüche, wobei in einem inneren Bereich des Saugnapfs (3) zwischen der Unterseite des Gehäuses (2) und in orthogonaler Richtung zur Ebene der umlaufenden Saugnapflippe mindestens ein Saugnapfabstandshalter (3b) angeordnet ist, der eine Höhe aufweist, die so bemessen ist, um beim Ansaugen des Saugnapfs (3) an die Oberfläche (20) ab einem Anstoß-Unterdruck an der Oberfläche (20) anzustoßen und bei einem weiteren Ansteigen des Unterdrucks den Abstand zwischen dem Telematik-Modul (1) und der Oberfläche (20) konstant zu halten.

11. Telematik-Vorrichtung gemäß einem oder mehreren der vorstehenden Ansprüche, wobei der zu überwachende Gegenstand ein Kraftfahrzeug, ein Lastkraftwagen, ein Baufahrzeug oder ein anderes Fahrzeug ist.

12. Telematik-Vorrichtung gemäß einem oder mehreren der vorstehenden Ansprüche, wobei das Datenfunkgerät (10) ein Mobilfunkgerät ist; und/oder das Datenfunkgerät (10) eine weitere Sensorik und einen Mikrokontroller umfasst und ausgebildet ist, Sensorsignale der weiteren Sensorik vom Mikrokontroller vorverarbeitet oder nicht vorverarbeitet zur Überwachungsstation (21) zu senden.

13. Telematik-Vorrichtung gemäß einem oder mehreren der vorstehenden Ansprüche , wobei die Funkverbindung zwischen dem Kurzstrecken-Funkmodul des Datenfunkgeräts (10) und dem Funkmodul (7) des Telematik-Moduls (1) auf einer authentifizierten und/oder einer verschlüsselten Verbindung beruht.

14. Verfahren zur Erkennung eines unerlaubten Lösens einer Verbindung zwischen einem Telematik-Modul (1) und einer glatten Oberfläche (20) eines zu überwachenden Gegenstandes und zur Übermittlung von Telematikmoduldaten an eine Überwachungsstation (21), wobei das Telematik-Modul (1) ein Gehäuse (2) mit einem Saugnapf (3) aufweist und mit dem zu überwachenden Gegenstand über den Saugnapf (3) so verbindbar ist, dass der Saugnapf (3) luftdicht an der glatten Oberfläche (20) anliegt und in seinem Inneren einen Hohlraum (4) bildet, der zur Oberfläche (20) hin offen ist, um im Hohlraum (4) einen Unterdruck gegenüber der Atmosphäre bilden zu können, der die Verbindung zwischen dem Saugnapf (3) und der Oberfläche (20) herstellt;
folgende Schritte umfassend:
a) Anordnen eines Drucksensors (5) im Telematik-Modul (1), so dass er mit dem Hohlraum (4) in Verbindung steht und ein entsprechendes Drucksignal erzeugt;
b) Anordnen eines Detektors (6) im Telematik-Modul (1), in dem mindestens ein Schwellwert zu einer Drucksignaländerung abgespeichert ist, die typisch ist, überschritten zu werden, wenn das unerlaubte Lösen der Verbindung vorliegt;
c) Abspeichern eines ersten Drucksignalwerts und Bestimmen aus einem nachfolgenden, zweiten Drucksignalwert eine Drucksignaländerung;
d) Vergleichen der Drucksignaländerung mit dem mindestens einen Schwellwert, wobei, wenn eine Überschreitung des mindestens einen Schwellwerts erkannt wird, das Lösen der Verbindung erkannt und ein Alarmsignal erzeugt, abgespeichert wird;
und
e) Übermitteln des Alarmsignals zu einer Überwachungsstation (21);
**dadurch gekennzeichnet, dass**
f) im Telematik-Modul (1) eine Sensorik (8) mit einem Beschleunigungssensor (8a) angeordnet und dementsprechend über die Telematikmoduldaten Messdaten des Beschleunigungssensors (8a) übertragen werden;
g) die Telematikmoduldaten vom Telematik-Modul (1) zu einem zusätzlichen Datenfunkgerät (10) drahtlos per einem Kurzstreckenfunkmodul übertragen werden;
und
h) zumindest ein Teil der Telematikmoduldaten vom Datenfunkgerät (10) zur Überwachungsstation per einem Langstreckenfunkmodul übertragen wird, das auf einem Mobilfunkstandard wie GSM, GPRS, EDGE, HSDPA, HSUPA, UMTS, LTE, CDMA oder einem anderen vergleichbaren Mobilfunkstandard basiert.
